# EUROPÄISCHE PATENTSCHRIFT

(11) **EP 0 631 379 B1**
(45) Veröffentlichungstag und Bekanntmachung des Hinweises auf die Patenterteilung: **07.01.1998**
(21) Anmeldenummer: 94108503.7
(22) Anmeldetag: 03.06.1994
(51) Int. Cl.: H03D 7/14

(54) **HF-Mischstufe in Basisschaltung**
HF mixer stage in common base
Etage mélangeur haute fréquence à base commune

(30) Priorität: 21.06.1993 DE 4320457
(43) Veröffentlichungstag der Anmeldung: 28.12.1994
(73) Patentinhaber: TEMIC TELEFUNKEN microelectronic GmbH, 74072 Heilbronn (DE)
(72) Erfinder: Sapotta, Hans, Dr., D-74078 Heilbronn (DE); Rinderle, Heinz, D-74080 Heilbronn (DE)
(74) Vertreter: Maute, Hans-Jürgen, Dipl.-Ing.

(56) Entgegenhaltungen:
- EP-A- 0 073 929
- EP-A- 0 557 741
- US-A- 4 080 573
- US-A- 4 310 810

## Beschreibung

Die Erfindung betrifft eine HF-Mischstufe in Basisschaltung gemäß dem Oberbegriff des Patentanspruches 1, wie sie aus der EP 0 557 741 A1 bekannt ist.

Multiplikative Mischstufen zur Frequenzumsetzung werden im HF-Bereich vielfältig eingesetzt - beispielsweise wird in Radios nach dem Superheterodyn-Empfängerprinzip das empfangene HF-Signal in die Zwischenfrequenzebene (ZF-Ebene) umgesetzt. Multiplikative HF-Mischstufen bestehen aus einem "aktiven Teil" mit einer (Differenz-) Verstärkerstufe mit zwei Verstärkertransistoren, denen jeweils zwei Schalttransistoren zugeordnet sind, sowie aus Schaltungsmitteln zur phasenrichtigen Addition der Ströme durch die Schalttransistoren; die Verstärkertransistoren werden dabei entweder in Emitterschaltung (Gilbert-Zelle) oder - für höhere Transitfrequenzen - in Basisschaltung realisiert. Solche multiplikative HF-Mischstufen werden beispielsweise in der EP 0 073 929 A3 beschrieben.
Ein Nachteil derartiger HF-Mischstufen ist die recht geringe Großsignalfestigkeit - beispielsweise wirkt sich dies bei Radio-Empfängern als Dynamikverlust auf die gesamte Signalverarbeitung aus und stellt angesichts der wachsenden Senderdichte ein gravierendes Problem dar. Darüber hinaus müssen HF-Mischstufen in Basisschaltung üblicherweise immer symmetrisch angesteuert werden; falls sie jedoch (asymmetrische) Eintaktsignale verarbeiten sollen - beispielsweise ist bei Radio-Empfängern der Schwingkreis zwischen Vorstufe und HF-Mischstufe unsymmetrisch -, sind zusätzliche Symmetrierglieder erforderlich.

Der Erfindung liegt die Aufgabe zugrunde, eine HF-Mischstufe in Basisschaltung gemäß dem Oberbegriff des Patentanspruchs 1 anzugeben, die vorteilhafte Eigenschaften bezüglich Großsignalfestigkeit und Einspeisung des Eingangssignals aufweist und bei der das Ausgangssignal auf vorteilhafte Weise verarbeitet werden kann.
Diese Aufgabe wird erfindungsgemäß durch die Merkmale im Kennzeichen des Patentanspruchs 1 gelöst.
Vorteilhafte Weiterbildungen der Erfindung ergeben sich aus den Unteransprüchen.

Bei der vorgestellten HF-Mischstufe ist die Verstärkerstufe des "aktiven Teils" nicht als Differenzverstärker ausgebildet - vielmehr wird die Differenzbildung aufgrund des unterschiedlichen Leitfähigkeitstyps der beiden Verstärkertransistoren erreicht. Von den Verstärkertransistoren wird der aufgeteilte Eingangsstrom den zugeordneten Schalttransistoren der Schaltstufe zugeführt; dazu wird der Kollektor des jeweiligen Verstärkertransistors mit den Emittern der zugeordneten Schalttransistoren verbunden. Die Ausgänge des "aktiven Teils" der Mischstufe werden durch die Kollektoren der Schalttransistoren gebildet. An den beiden Kollektorknotenpunkten (Ausgangsknotenpunkten) der Schaltstufen kann das Ausgangssignal differentiell - beispielsweise mit einem Schwingkreis, dessen Spule als Primärwicklung eines Transformators arbeitet - abgegriffen werden.

Die HF-Mischstufe vereinigt mehrere Vorteile in sich:
- Es wird eine gute Großsignalfestigkeit und damit auch Dynamik des Empfangsteils erreicht; dies bedeutet, daß die Linearität der Signalübertragung erhöht wird, was sich beispielsweise im Intermodulations-Verhalten äußert - der "Interception Point" kann beispielsweise beträchtlich gesteigert oder/und gleichzeitig der Strombedarf verringert werden.
- Da die Schaltung nur einen Eingang aufweist, ist eine Eintaktansteuerung bzw. asymmetrische Einspeisung des Eingangssignals möglich; auf Symmetrierglieder kann verzichtet werden.
- Durch die Verbindung der Kollektoren der Schalttransistoren unterschiedlicher Schaltstufen kann das Ausgangssignal am Ausgangsanschluß auf einfache Weise abgegriffen werden.

Die Erfindung soll weiterhin anhand der Figuren 1 bis 4 beschrieben werden.

Es zeigen:
- Figur 1: eine Schaltungsanordnung als Ausführungsbeispiel der HF-Mischstufe.
- Figur 2: eine alternative Schaltungsanordnung mit einer mittels Transformator realisierten Eingangsankopplung.
- Figur 3: ein Ausführungsbeispiel zur Erzeugung der Basisspannung der Verstärkertransistoren.
- Figur 4: ein anderes Ausführungsbeispiel zur Erzeugung der Basisspannung der Verstärkertransistoren.

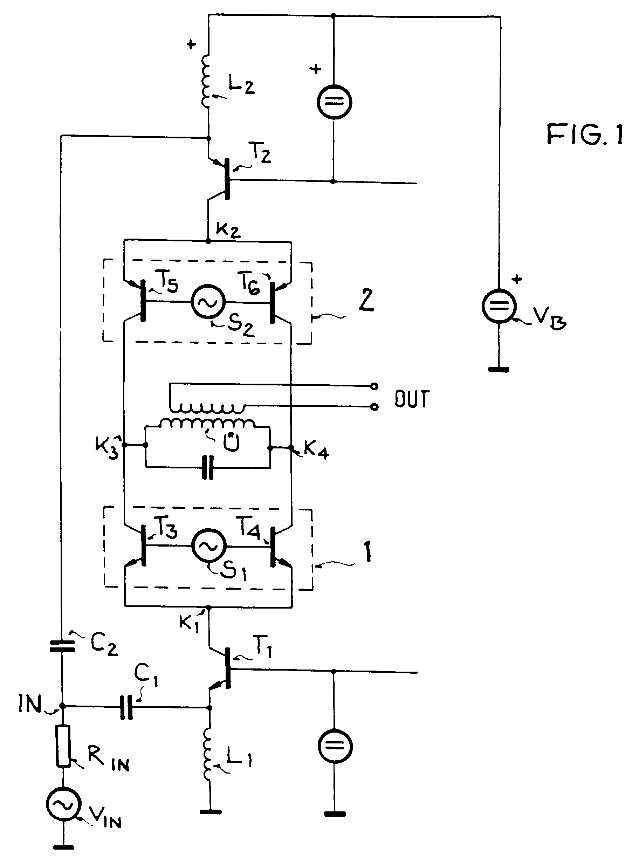

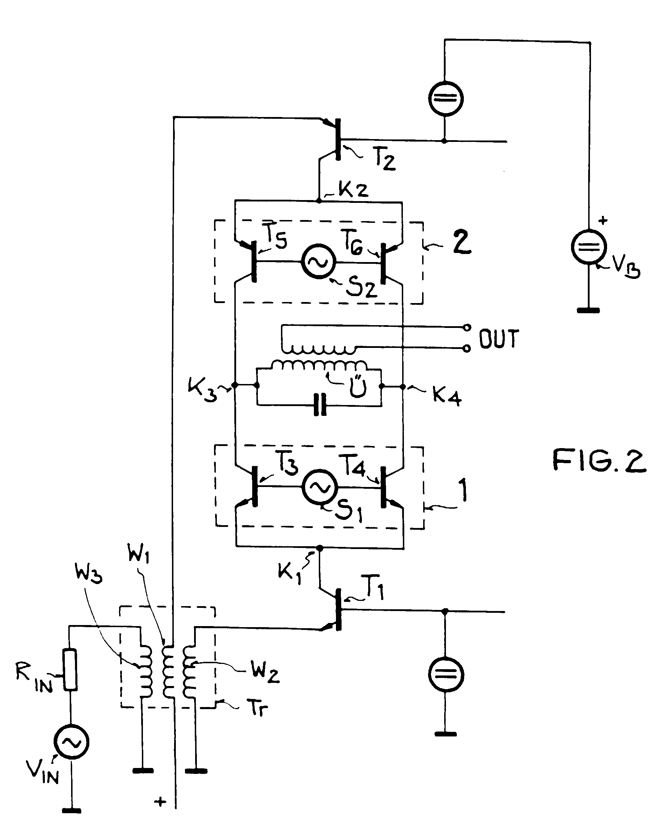

Gemäß der Figur 1 weist die HF-Mischstufe die beiden emittergekoppelten Verstärkertransistoren T₁ und T₂ auf, wobei der Schaltungseingang IN - an diesem wird das HF-Eingangssignal der Eingangssignalquelle V_{IN} eingespeist - durch den Kopplungspunkt der beiden Emitter der Verstärkertransistoren T₁ und T₂ gebildet wird. Die Arbeitspunkte der beiden Verstärkertransistoren T₁ und T₂ können auf vielfältige Art vorgegeben werden - beispielsweise gemäß Figur 1 und 2 mittels Vorspannung der Basen der Verstärkertransistoren T₁ und T₂. An den Kollektor des ersten Verstärkertransistors T₁ ist die erste Schaltstufe 1 mit den beiden emittergekoppelten Schalttransistoren T₃ und T₄, an den Kollektor des zweiten Verstärkertransistors T₂ die zweite Schaltstufe 2 mit den beiden emittergekoppelten Schalttransistoren T₅ und T₆ angeschlossen. Den Basen der Schalttransistoren T₃, T₄ bzw. T₅, T₆ werden neben geeigneten Vorspannungssignalen die Überlagerungssignale der Signalquellen S₁ bzw. S₂ (beispielsweise das Signal eines Oszillators OSZ) zugeführt. Die miteinander verbundenen Kollektoren der Schalttransistoren T₃ und T₅ bilden den ersten Ausgangsknotenpunkt K₃, die miteinander verbundenen Kollektoren der Schalttransistoren T₄ und T₆ bilden den zweiten Ausgangsknotenpunkt K₄ des "aktiven Teils" der Mischstufe; an den beiden Ausgangsknotenpunkten K₃ bzw. K₄ kann das Ausgangssignal - beispielsweise mittels des Übertragers Ü - in differentieller Form abgenommen werden. Die beiden Verstärkertransistoren T₁ und T₂ sind vom komplementären Leitungstyp, wobei gemäß der Figur 1 der (mit dem negativen Pol der Versorgungsspannungsquelle V_{B} verbundene) erste Verstärkertransistor T₁ ein NPN-Transistor und der (mit dem positiven Pol der Versorgungsspannungsquelle V_{B} verbundene) zweite Verstärkertransistor T₂ ein PNP-Transistor ist. Die Schalttransistoren T₃, T₄ bzw. T₅, T₆ der Schaltstufe 1 bzw. 2 sind vom gleichen Leitfähigkeitstyp wie der Verstärkertransistor T₁ bzw. T₂, dem sie zugeordnet sind; demnach sind gemäß Figur 1 die beiden Schalttransistoren T₃, T₄ der Schaltstufe 1 NPN-Transistoren, während die Schalttransistoren T₅, T₆ der Schaltstufe 2 als PNP-Transistoren ausgebildet sind.
Die Einkopplung des von der Signalquelle V_{IN} mit dem Innenwiderstand R_{IN} gelieferten Eingangssignals am Schaltungseingang IN erfolgt gemäß Figur 1 über die beiden Kondensatoren C₁ und C₂. Alternativ dazu kann hierfür - wie in der Figur 2 dargestellt - auch ein Transformator Tr mit 3 Wicklungen W₁, W₂, W₃ vorgesehen werden, bei dem jeweils eine der Wicklungen W₁ bzw. W₂ mit dem Emitter eines der Verstärkertransistoren T₁ bzw. T₂ verbunden ist und die dritte Wicklung W₃ zur Einkopplung des Eingangssignals mit der Signalquelle V_{IN} verbunden ist.

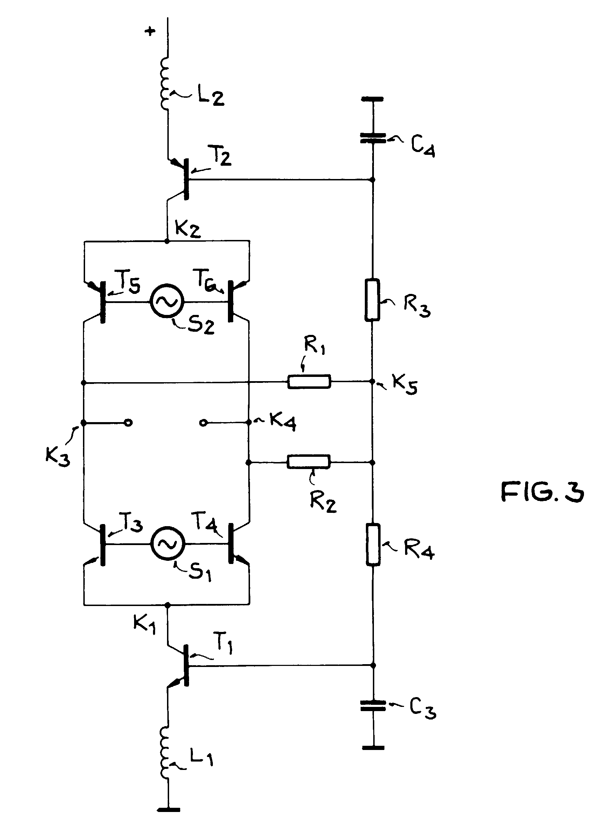

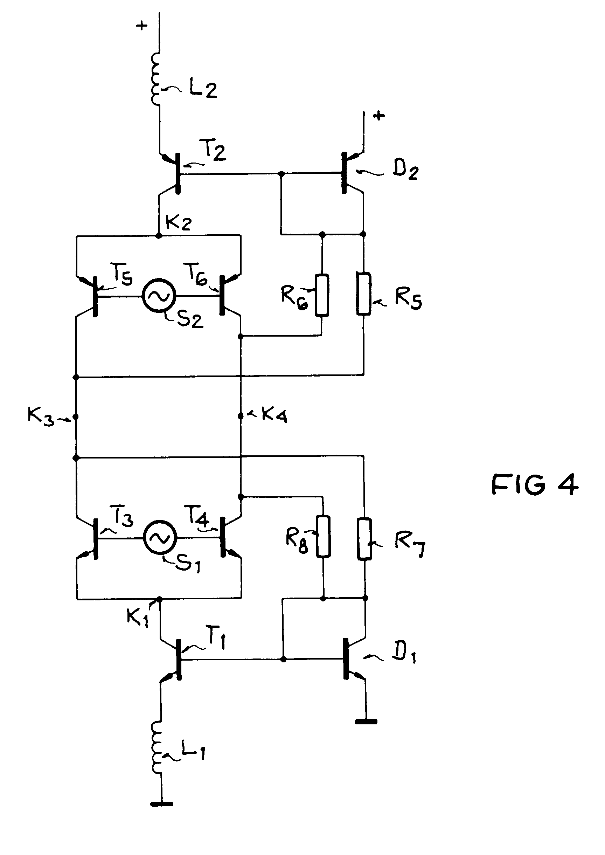

In den Figuren 3 und 4 sind zwei Ausführungsbeispiele zur Erzeugung der Basisspannung der beiden Verstärkertransistoren T₁, T₂ dargestellt, mit denen eine Stabilisierung des Arbeitspunkts der Verstärkertransistoren T₁, T₂ gegenüber der reinen Basisvorspannung gemäß Figur 1 und 2 erreicht werden kann.
Gemäß der Figur 3 sind hierzu die Widerstände R₁, R₂, R₃ und R₄ vorgesehen: ein Anschluß der beiden Widerstände R₃, R₄ ist mit der Basis eines der beiden Verstärkertransistoren T₁, T₂ verbunden, die beiden anderen Anschlüsse sind am Knotenpunkt K₅ miteinander verbunden; an diesem Knotenpunkt K₅ ist jeweils ein Anschluß der beiden Widerstände R₁, R₂ angeschlossen, deren anderer Anschluß mit jeweils einem Ausgangsknotenpunkt K₃, K₄ verbunden ist. Hierdurch wird den Basen der beiden Verstärkertransistoren T₁, T₂ eine Gleichspannungsgegenkopplung zugeführt, die der Arbeitspunktstabilisierung und der Toleranzkompensation dient. Die beiden an den Basen der Verstärkertransistoren T₁, T₂ angeschlossenen Kondensatoren C₃ und C₄ dienen zur Abblockung der eventuell ebenfalls gegengekoppelten HF-Anteile.
Alternativ dazu wird gemäß Figur 4 der Mittelwert der Spannung an den Ausgangsknotenpunkten K₃, K₄ durch Widerstände R₅, R₆, R₇, R₈ generiert und über Stromspiegel (Dioden D₁, D₂) den Basen der beiden Verstärkertransistoren T₁, T₂ zugeführt.

Mit der vorgestellten Schaltung kann die Linearität der Übertragung (die sich beispielweise im Intermodulationsverhalten bzw. Interception Point äußert) bedeutend erhöht werden bzw. der benötigte Strom reduziert werden; gleichzeitig wird jedoch das Rauschverhalten nicht verschlechtert.
Daher wird die Schaltung vorzugsweise überall dort eingesetzt, wo eine hohe Linearität und/oder ein geringer Strombedarf benötigt wird. Als Beispiele hierzu seien beispielsweise Cordless-Telefon-Anwendungen, Empfängerschaltungen, die nach dem Prinzip der Direktmischung arbeiten, Phasenkomparatoren, hochlineare Multipliziererschaltungen etc. genannt.

## Patentansprüche

1. HF-Mischstufe in Basisschaltung, mit
a) zwei bipolaren Verstärkertransistoren (T₁, T₂) von unterschiedlichem Leitungstyp,
b) zwei jeweils einem Verstärkertransistor (T₁, T₂) zugeordneten Schaltstufen (1, 2) mit jeweils zwei emittergekoppelten bipolaren Schalttransistoren (T₃, T₄ bzw. T₅, T₂) vom gleichen Leitungstyp wie der zugeordnete Verstärkertransistor (T₁, T₂) und mit zwei Signalquellen (S₁ bzw. S₂), die die Basen der Schalttransistoren (T₃, T₄ bzw. T₅, T₆) mit Überlagerungssignalen beaufschlagen,
c) zwei Knotenpunkten (K₁ bzw. K₂), an denen die Emitter der Schalttransistoren (T₃, T₄ bzw. T₅, T₂) jeweils mit dem Kollektor des zugehörigen Verstärkertransistors (T₁ bzw. T₂) verbunden sind,
d) Schaltungsmitteln (C₁, C₂, Tr) zur Potentialtrennung, über die die Emitter der Verstärkertransistoren (T₁, T₂) miteinander verbunden sind,
e) einer Eingangssignalquelle (V_{IN}) mit zugehörigem Innenwiderstand (R_{IN}), deren eine Klemme über den Schaltungseingang (IN) mit den Schaltungsmitteln (C₁, C₂, Tr) zur Potentialtrennung und deren andere Klemme mit Bezugspotential verbunden ist und deren Signal durch die HF-Mischstufe in einen anderen Frequenzbereich transponiert werden soll,
gekennzeichnet dadurch, daß
f) die Kollektoren jeweils zweier Schalttransistoren (T₃, T₅ bzw. T₄, T₆) unterschiedlicher Schaltstufen (1, 2) an jeweils einem weiteren Knotenpunkt (K₃, K₄) direkt miteinander verbunden sind.

2. Mischstufe nach Anspruch 1, dadurch gekennzeichnet, daß durch Schaltungsmittel der beiden Signalquellen (S₁ bzw. S₂) der Schaltstufen (1 bzw. 2) die Gleichtaktspannung an den Basen der Schalttransistoren (T₃, T₄ bzw. T₅, T₆) derart eingestellt wird, daß der Mittelwert der Spannung gegen Bezugspotential an den Basen der Schalttransistoren (T₃, T₄ bzw. T₅, T₆) einer Schaltstufe (1 bzw. 2) identisch ist.

3. Mischstufe nach Anspruch 1 oder 2, dadurch gekennzeichnet, daß die beiden Schalttransistoren (T₃, T₄ bzw. T₅, T₆) einer Schaltstufe (1 bzw. 2) durch die Überlagerungssignale der Signalquellen (S₁ bzw. S₂) derartig komplementär angesteuert werden, daß jeweils einer der beiden Schalttransistoren (T₃, T₆) einer Schaltstufe (1, 2) in den leitenden bzw. sperrenden Zustand und der andere Schalttransistor (T₄, T₅) der Schaltstufe (1, 2) in den sperrenden bzw. leitenden Zustand übergeht.

4. Mischstufe nach einem der Ansprüche 1 bis 3, dadurch gekennzeichnet, daß der Schaltungsausgang (OUT) durch die weiteren Knotenpunkte (K₃ bzw. K₄) gebildet wird, zwischen denen die Ausgangsspannung (U_{OUT}) über Schaltungsmittel (Ü) in differentieller Form abgenommen wird.

5. Mischstufe nach einem der Ansprüche 1 bis 4, dadurch gekennzeichnet, daß Schaltungsmittel (L₁) vorgesehen sind, über die der Emitter des NPN-Verstärkertransistors (T₁) zur DC-Versorgung und AC-Abtrennung mit dem negativen Anschluß der Versorgungsspannungsquelle (V_{B}) verbunden ist.

6. Mischstufe nach einem der Ansprüche 1 bis 5, dadurch gekennzeichnet, daß Schaltungsmittel (L₂) vorgesehen sind, über die der Emitter des PNP-Verstärkertransistors (T₂) zur DC-Versorgung und AC-Abtrennung mit dem positiven Anschluß der Versorgungsspannungsquelle (V_{B}) verbunden ist.

7. Mischstufe nach einem der Ansprüche 1 bis 6, dadurch gekennzeichnet, daß Schaltungsmittel (C₁, C₂) zur DC-Abtrennung vorgesehen sind, über die das am Schaltungseingang (IN) anliegende Eingangssignal in die Emitter der Verstärkertransistoren (T₁, T₂) parallel eingespeist wird.

8. Mischstufe nach einem der Ansprüche 1 bis 6, dadurch gekennzeichnet, daß zur Einkopplung des Eingangssignals ein Transformator (Tr) mit 3 Wicklungen vorgesehen ist, daß die erste Wicklung (W₁) des Transformators (Tr) an einem Pol mit dem Emitter des PNP-Verstärkertransistors (T₂) und am anderen Pol mit dem positiven Anschluß der Versorgungsspannungsquelle (V_{B}) verbunden ist, daß die zweite Wicklung (W₂) des Transformators (Tr) an einem Pol mit dem Emitter des NPN-Verstärkertransistors (T₁) und am anderen Pol mit dem negativen Anschluß der Versorgungsspannungsquelle (V_{B}) verbunden ist, und daß die dritte Wicklung (W₃) des Transformators (Tr) mit einem Pol an die Eingangssignalquelle (V_{IN}) angeschlossen ist.

9. Mischstufe nach einem der Ansprüche 1 bis 8, dadurch gekennzeichnet, daß an den Ausgangsknoten (K₃, K₄) Schaltungsmittel (R₁ - R₄) vorgesehen sind, durch die zur Stabilisierung der Arbeitspunkte der Verstärkertransistoren (T₁, T₆) eine für Gleichstrom wirksame Gegenkopplung auf die Basen der Verstärkertransistoren (T₁, T₂) vorgenommen wird.

10. Mischstufe nach Anspruch 9, dadurch gekennzeichnet, daß als Schaltungsmittel zwei Widerstände (R₃, R₄) vorgesehen sind, deren erster Anschluß an einem Knotenpunkt (K₅) miteinander verbunden ist und deren anderer Anschluß mit der Basis je eines Verstärkertransistors (T₁, T₂) verbunden ist, und daß am Knotenpunkt (K₅) eine Spannung anliegt, die dem Mittelwert der Spannung an den beiden Ausgangsknotenpunkten (K₃, K₄) entspricht.

11. Mischstufe nach Anspruch 10, dadurch gekennzeichnet, daß der Mittelwert der Spannung an den beiden Ausgangsknotenpunkten (K₃, K₄) über zwei Widerstände (R₁, R₂) erzeugt wird, daß je ein Anschluß der beiden Widerstände (R₁, R₂) mit einem Ausgangsknoten (K₃, K₄) verbunden ist, und daß der andere Anschluß der beiden Widerstände (R₁, R₂) am Knotenpunkt (K₅) miteinander verbunden ist.

12. Mischstufe nach einem der Ansprüche 1 bis 11, dadurch gekennzeichnet, daß an die Basen der Verstärkertransistoren (T₁, T₂) Schaltungsmittel (C₃, C₄) zur HF-Abblockung angeschlossen sind.

13. Mischstufe nach Anspruch 9, dadurch gekennzeichnet, daß als Schaltungsmittel zwei Dioden (D₁, D₂) vorgesehen sind, die derart in Flußrichtung mit den Basen der Verstärkertransistoren (T₁, T₂) und jeweils mit dem Minuspol bzw. dem Pluspol der Versorgungsspannungsquelle (V_{B}) verbunden sind, daß jeweils ein Stromspiegel zur Gleichstromeinstellung im Mischer gebildet wird.

14. Mischstufe nach Anspruch 13, dadurch gekennzeichnet, daß die Referenzströme der beiden Stromspiegel über Schaltungsmittel (R₅ - R₈) aus den Mittelwerten der Spannung an den Ausgangsknotenpunkten (K₃, K₄) generiert werden.

## Claims

1. A HF mixer stage with a common base connection having
a) two bipolar amplifier transistors (T₁, T₂) of different conductivity type,
b) two switching stages (1, 2) in each case assigned to an amplifier transistor (T₁, T₂) and each having two emitter-coupled bipolar switching transistors (T₃, T₄ and T₅, T₆) of the same conductivity type as the assigned amplifier transistor (T₁, T₂) and two signal sources (S₁ and S₂) which supply the bases of the switching transistors (T₃, T₄ and T₅, T₆) with superimposed signals,
c) two nodes (K₁ and K₂) at which the emitters of the switching transistors (T₃, T₄ and T₅, T₆) are in each case connected to the collector of the associated amplifier transistor (T₁ and T₂),
d) circuit elements (C₁, C₂, Tr) for potential-separation, via which the emitters of the amplifier transistors (T₁, T₂) are connected to one another,
e) an input signal source (V_{IN}) with associated internal resistor (R_{IN}), one terminal of which is connected via the circuit input (IN) to the circuit elements (C₁, C₂, Tr) for potential-separation and the other terminal of which is connected to reference potential and the signal of which is to be transposed into another frequency range by the HF mixer stage.
characterised in that
f) the collectors of in each case two switching transistors (T₃, T₅ and T₄, T₆) of different switching stages (1, 2) are in each case directly connected to one another at a further node (K₃, K₄).

2. A mixer stage according to Claim 1, characterised in that by circuit elements of the two signal sources (S₁ and S₂) of the switching stages (1 and 2) the common-mode voltage across the bases of the switching transistors (T₃, T₄ and T₅, T₆) is set such that the mean value of the voltage to reference potential across the bases of the switching transistors (T₃, T₄ and T₅, T₆) of a switching stage (1 and 2) is identical.

3. A mixer stage according to Claim 1 or 2, characterised in that the two switching transistors (T₃, T₄ and T₅, T₆) of a switching stage (1 and 2) are driven in complementary fashion by the superimposed signals of the signal sources (S₁ and S₂) in such manner that in each case one of the two switching transistors (T₃, T₆) of a switching stage (1, 2) assumes the conductive state and blocking state respectively, and other switching transistor (T₄, T₅) of the switching stage (1, 2) assumes the blocking state and conductive state respectively.

4. A mixer stage according to one of Claims 1 to 3, characterised in that the circuit output (OUT) is formed by the further nodes (K₃ and K₄), between which the output voltage (U_{OUT}) is tapped in differential form via circuit elements (Ü).

5. A mixer stage according to one of Claims 1 to 4, characterised in that circuit elements (L₁) are provided via which the emitter of the NPN amplifier transistor (T₁) is connected, for d.c.- supply and a.c.- isolation, to the negative terminal of the supply voltage source (V_{B}).

6. A mixer stage according to one of Claims 1 to 5, characterised in that circuit elements (L₂) are provided via which the emitter of the PNP amplifier transistor (T₂) is connected, for d.c.- supply and a.c.- isolation, to the positive terminal of the supply voltage source (V_{B}).

7. A mixer stage according to one of Claims 1 to 6, characterised in that circuit elements (C₁, C₂) for d.c. isolation are provided, via which the input signal applied to the circuit input (IN) is fed in parallel into the emitters of the amplifier transistors (T₁, T₂).

8. A mixer stage according to one of Claims 1 to 6, characterised in that for the input-coupling of the input signal a transformer (Tr) with three windings is provided, that the first winding (W₁) of the transformer (Tr) is connected by one pole to the emitter of the PNP amplifier transistor (T₂) and by the other pole to the positive terminal of the supply voltage source (V_{B}), that the second winding (W₂) of the transformer (Tr) is connected by one pole to the emitter of the NPN amplifier transistor (T₁) and by the other pole to the negative terminal of the supply voltage source (V_{B}) and that the third winding (W₃) of the transformer (Tr) is connected by one pole to the input signal source (V_{IN}).

9. A mixer stage according to one of Claims 1 to 8, characterised in that at the output nodes (K₃, K₄) circuit elements (R₁ - R₄) are provided by which, for the stabilisation of the operating points of the amplifier transistors (T₁, T₂), a negative feedback, effective for d.c., to the bases of the amplifier transistors (T₁, T₂) takes place.

10. A mixer stage according to Claim 9, characterised in that as circuit elements two resistors (R₃, R₄) are provided, the respective first terminals of which are connected to one another at a node (K₅) and the respective other terminals of which are in each case connected to the base of an amplifier transistor (T₁, T₂), and that a voltage corresponding to the mean value of the voltage at the two output nodes (K₃, K₄) is applied to the node (K₅).

11. A mixer stage according to Claim 10, characterised in that the mean value of the voltage at the two output nodes (K₃, K₄) is generated via two resistors (R₁, R₂), that the one terminals of the two resistors (R₁, R₂) are in each case connected to an output node (K₃, K₄) respectively and that the other terminals of the two resistors (R₁, R₂) are connected to one another at the node (K₅).

12. A mixer stage according to one of Claims 1 to 11, characterised in that circuit elements (C₃, C₄) for HF-blocking are connected to the bases of the amplifier transistors (T₁, T₂).

13. A mixer stage according to Claim 9, characterised in that as circuit elements two diodes (D₁, D₂) are provided, which are connected in the forward direction to the bases of the amplifier transistors (T₁, T₂) and in each case to the minus pole and plus pole respectively of the supply voltage source (V_{B}) in such manner that a current mirror for d.c.-setting in the mixer is in each case formed.

14. A mixer stage according to Claim 13, characterised in that the reference currents of the two current mirrors are generated via circuit elements (R₅ - R₈) from the mean values of the voltage at the output nodes (K₃, K₄).

## Revendications

1. Etage mélangeur HF à base commune, équipé
a) de deux transistors amplificateurs bipolaires (T₁, T₂) de type de conductivité différent,
b) de deux étages de commutation (1, 2) associés respectivement à un transistor amplificateur (T₁, T₂) comportant chacun deux transistors de commutation bipolaires à couplage d'émetteur (T₃, T₄ ou T₅, T₆) de même type de conductivité que le transistor amplificateur associé (T₁, T₂) et avec deux sources de signaux (S₁ ou S₂), qui alimentent les bases des transistors de commutation (T₃, T₄ ou T₅, T₆) en signaux de conversion,
c) de deux noeuds (K₁ ou K₂), auxquels sont réunis les émetteurs des transistors de commutation (T₃, T₄ ou T₅, T₆) respectivement au collecteur du transistor amplificateur associé (T₁ ou T₂),
d) de deux moyens de circuit (C₁, C₂, Tr) en vue de la séparation de potentiel, par l'intermédiaire desquels les émetteurs des transistors amplificateurs (T₁, T₂) sont réunis,
e) d'une source de signal d'entrée (V_{ENTREE}) de résistance interne associée (R_{ENTREE}), dont une borne est reliée par l'intermédiaire de l'entrée de circuit (ENTREE) aux moyens de circuit (C₁, C₂, Tr) en vue de la séparation de potentiel et dont l'autre borne est reliée au potentiel de référence et dont le signal doit être transposé par l'étage mélangeur HF dans une autre plage de fréquence,
caractérisé en que
f) les collecteurs de deux transistors de commutation (T₃, T₅ ou T₄, T₆) d'étages de commutation différents (1, 2) sont réunis directement respectivement à un autre noeud (K₃, K₄).

2. Etage mélangeur selon la revendication 1, caractérisé en ce que, par des moyens de circuit des deux sources de signaux (S₁ ou S₂) des étages de commutation (1, 2, respectivement), la tension de synchronisme sur les bases des transistors de commutation (T₃, T₄, respectivement T₅, T₆) est réglée de telle sorte que la valeur moyenne de la tension vis-à-vis du potentiel de référence est identique sur les bases des transistors de commutation (T₃, T₄, respectivement T₅, T₆) d'un étage de commutation (1, 2, respectivement).

3. Etage mélangeur selon la revendication 1 ou 2, caractérisé en ce que les deux transistors de commutation (T₃, T₄, respectivement T₅, T₆) d'un étage de commutation (1 , 2, respectivement) sont commandés par les signaux de conversion des sources de signaux (S₁ ou S₂) de façon complémentaire de telle sorte qu'un des deux transistors de commutation (T₃, T₆) d'un étage de commutation (1, 2) passe de l'état conducteur à l'état non conducteur et l'autre transistor de commutation (T₄, T₅) de l'étage de commutation (1, 2) passe dans l'état non conducteur ou dans l'état conducteur, respectivement.

4. Etage mélangeur selon l'une quelconque des revendications 1 à 3, caractérisé en ce que la sortie du circuit (SORTIE) est formée par les autres noeuds (K₃, K₄, respectivement), entre lesquels la tension de sortie (U_{SORTIE}) est prélevée sous forme différentielle par l'intermédiaire de moyens de circuit (Ü).

5. Etage mélangeur selon l'une quelconque des revendications 1 à 4, caractérisé en ce que des moyens de circuit (L₁) sont prévus, par l'intermédiaire desquels l'émetteur du transistor amplificateur NPN (T₁) est relié en vue de l'alimentation continue et de la séparation alternative à la borne négative de la source de tension d'alimentation (V_{B}).

6. Etage mélangeur selon l'une quelconque des revendications 1 à 5, caractérisé en ce que des moyens de circuit (L₂) sont prévus, par l'intermédiaire desquels l'émetteur du transistor amplificateur PNP (T₂) est relié en vue de l'alimentation continue et de la séparation alternative à la borne positive de la source de tension d'alimentation (V_{B}).

7. Etage mélangeur selon l'une quelconque des revendications 1 à 6, caractérisé en ce que des moyens de circuit (C₁, C₂) en vue du découplage continu sont prévus, par l'intermédiaire desquels le signal d'entrée appliqué à l'entrée de circuit (ENTREE) est appliqué en parallèle aux émetteurs des transistors amplificateurs (T₁, T₂).

8. Etage mélangeur selon l'une quelconque des revendications 1 à 6, caractérisé en ce qu'en vue du couplage du signal d'entrée est prévu un transformateur (Tr) à trois enroulements, en ce que le premier enroulement (W₁) du transformateur (Tr) est relié à un pôle avec l'émetteur du transistor amplificateur PNP (T₂) et à l'autre pôle avec la borne positive de la source de tension d'alimentation (V_{B}), en ce que le second enroulement (W₂) du transformateur (Tr) est relié à un pôle avec l'émetteur du transistor amplificateur NPN (T₁) et par l'autre pôle à la borne négative de la source de tension d'alimentation (V_{B}), et en ce que le troisième enroulement (W₃) du transformateur (Tr) est relié par un pôle à la source de signal d'entrée (V_{ENTREE}).

9. Etage mélangeur selon l'une quelconque des revendications 1 à 8, caractérisé en ce qu'aux noeuds (K₃, K₄) sont prévus des moyens de circuit (R₁-R₄), par l'intermédiaire desquels, en vue de la stabilisation des points de fonctionnement des transistors amplificateurs (T₁, T₂) est assurée une contre-réaction efficace pour un courant continu sur les bases des transistors amplificateurs (T₁, T₂).

10. Etage mélangeur selon la revendication 9, caractérisé en ce qu'en tant que moyens de circuit sont prévues deux résistances (R₃, R₄), dont la première borne est reliée à un noeud (K₅) et dont l'autre borne est reliée à la base de chacun des transistors amplificateurs (T₁, T₂), et en ce qu'au noeud (K₅) apparaît une tension, qui correspond à la valeur moyenne de la tension sur les deux noeuds de sortie (K₃, K₄).

11. Etage mélangeur selon la revendication 10, caractérisé en ce que la valeur moyenne de la tension sur les deux noeuds de sortie (K₃, K₄) est générée par l'intermédiaire de deux résistances (R₁, R₂), en ce qu'une première borne des deux résistances (R₁, R₂) est reliée à un noeud de sortie (K₃, K₄), et en ce que l'autre borne des deux résistances (R₁, R₂) est reliée au noeud (K₅).

12. Etage mélangeur selon l'une quelconque des revendications 1 à 11, caractérisé en ce qu'aux bases des transistors amplificateurs (T₁, T₂) sont reliés des moyens de circuit (C₃, C₄) en vue du découplage HF.

13. Etage mélangeur selon la revendication 9, caractérisé en ce qu'en tant que moyens de circuit sont prévues deux diodes (D₁, D₂) qui sont reliées dans le sens passant avec les bases des transistors amplificateurs (T₁, T₂) et respectivement avec le pôle moins ou le pôle plus de la source de tension d'alimentation (V_{B}) de telle sorte qu'un miroir de courant est formé dans le mélangeur en vue du réglage du courant continu.

14. Etage mélangeur selon la revendication 13, caractérisé en ce que les courants de référence des deux miroirs de courant sont générés par l'intermédiaire de moyens de circuit (R₅-R₈) à partir des valeurs moyennes de la tension sur les noeuds de sortie (K₃, K₄).
